# EUROPEAN PATENT APPLICATION

(11) **EP 4 520 799 A1**
(43) Date of publication of application: **12.03.2025**
(21) Application number: 23819659.6
(22) Date of filing: 24.05.2023
(51) Int. Cl.: C09J 11/06, C09J 129/04, C09J 133/00, C09J 139/06, C09J 201/00, C09J 7/38, H01L 21/50, H01L 21/60, H01L 33/00

(54) **WATER-SOLUBLE ADHESIVE COMPOSITION FOR COMPONENT CAPTURE, WATER-SOLUBLE ADHESIVE SHEET FOR COMPONENT CAPTURE, AND METHOD FOR PRODUCING ELECTRONIC COMPONENT**

(30) Priority: 10.06.2022 JP 2022094725
(71) Applicant: NAGASE CHEMTEX CORPORATION, Osaka-shi, Osaka 550-8668 (JP)
(72) Inventor: YOSHIMATSU, Shuhei, Tatsuno-shi, Hyogo 679-4124 (JP); WATANABE, Keiji, Tatsuno-shi, Hyogo 679-4124 (JP)
(74) Representative: Frick, Robert
(86) International application number: PCT/JP2023/019404
(87) International publication number: WO 2023/238676

(57) **Abstract**

An object of the present invention is to provide a water-soluble adhesive composition for component capture and a water-soluble adhesive sheet for component capture which are superior in the impact absorption and the stickiness and adhesiveness and suitable for capturing components, and provide a method which allows high-precision, efficient production of electronic components, by using the composition and the sheet. To achieve the object, a composition and a sheet including the composition are provided, the composition containing an (A) water-soluble adhesive and a (B) water-soluble plasticizer (excluding the component (A)), wherein the (B) water-soluble plasticizer has 50000 mPa·s or less at normal temperature (25°C), and a ratio of a content of the (B) water-soluble plasticizer to a content of the (A) water-soluble adhesive ((B)/(A)) is greater than 0.5 and 3.0 or less. According to the present invention, impact absorption and the stickiness and adhesiveness are improved, and particularly in the production of a semiconductor element, damage or misalignment of a component (element) is reduced. Particularly the sheet of the present invention is easy to handle in attachment and peeling.

## Description

### TECHNICAL FIELD

The present invention relates to a water-soluble adhesive composition for component capture, a water-soluble adhesive sheet for component capture, and a method for producing an electronic component. The present invention relates in particular to a water-soluble adhesive composition for component capture and a water-soluble adhesive sheet for component capture, both for capturing an element on a substrate in producing an electronic component, and a method for producing an electronic component using the water-soluble adhesive composition for component capture and the water-soluble adhesive sheet for component capture.

### BACKGROUND ART

In producing electronic components such as semiconductor elements and display elements, materials having an adhesive layer (pressure-sensitive adhesive layer) are used to prevent adhesion of foreign substances or to produce semiconductor chips or image display devices efficiently.

For example, Patent Document 1 suggests a production method for a display device using light-emitting diodes (LEDs). The production method includes forming a large number of LED elements, which will be pixels, on one wafer, followed by dicing and enlargement transfer using a temporary holding member having an adhesive layer (pressure-sensitive adhesive layer).

Patent Document 2 suggests a method of separating an LED element from a base by using a laser beam in enlargement transfer.

### CITATION LIST

### PATENT DOCUMENT

Patent Document 1: Japanese Unexamined Patent Publication No. 2002-261335
Patent Document 2: Japanese Unexamined Patent Publication No. 2010-161221

### SUMMARY OF THE INVENTION

### TECHNICAL PROBLEM

However, when LED elements are transferred from a transfer source substrate to a transfer target substrate by transfer, an LED element may be displaced from a predetermined position on the transfer target substrate. Further, an LED element may collide with a transfer target member, resulting in failure to place the LED element at a desired position due to a rebound.

It is therefore an object of the present invention to provide a water-soluble adhesive composition for component capture and a water-soluble adhesive sheet for component capture which are superior in the impact absorption and the stickiness and adhesiveness and suitable for capturing components, and provide a method which allows high-precision, efficient production of electronic components, by using the water-soluble adhesive composition for component capture and the water-soluble adhesive sheet for component capture.

### SOLUTION TO THE PROBLEM

According to an aspect of the present invention, a water-soluble adhesive composition for component capture containing an (A) water-soluble adhesive and a (B) water-soluble plasticizer (excluding the component (A)) is provided, wherein the (B) water-soluble plasticizer has a viscosity of 50000 mPa·s or less at normal temperature (25°C), and a ratio ((B)/(A)) of a content of the (B) water-soluble plasticizer to a content of the (A) water-soluble adhesive is greater than 0.5 and 3.0 or less.

According to the water-soluble adhesive composition for component capture of the present invention, a water-soluble plasticizer having a viscosity of 50000 mPa·s or less at normal temperature (25°C) is contained at a predetermined ratio with respect to the content of the water-soluble adhesive. It is thus possible to improve impact absorption and the stickiness and adhesiveness of the water-soluble adhesive composition for component capture, and reduce damage or misalignment of a component (element) particularly in the production of an electronic component.

According to an aspect of the present invention, a water-soluble adhesive composition for component capture containing an (A) water-soluble adhesive and a (B) water-soluble plasticizer (excluding the component (A)) is provided, wherein the (B) water-soluble plasticizer is in liquid form at normal temperature (25°C) and has a molecular weight of 5000 or less, and a ratio ((B)/(A)) of a content of the (B) water-soluble plasticizer to a content of the (A) water-soluble adhesive is greater than 0.5 and 3.0 or less.

According to the water-soluble adhesive composition for component capture of the present invention, a water-soluble plasticizer being in liquid form and having a molecular weight of 5000 or less is contained at a predetermined ratio with respect to the content of the water-soluble adhesive. It is thus possible to improve impact absorption and the stickiness and adhesiveness of the water-soluble adhesive composition for component capture, and reduce damage or misalignment of a component (element) particularly in the production of an electronic component.

According to an aspect of the present invention, a water-soluble adhesive composition for component capture containing an (A) water-soluble adhesive and a (B) water-soluble plasticizer (excluding the component (A)) is provided, wherein the (A) water-soluble adhesive has a weight-average molecular weight of 1.0 × 10⁴ or more and 1.0 × 10⁶ or less, and a ratio ((B)/(A)) of a content of the (B) water-soluble plasticizer to a content of the (A) water-soluble adhesive is greater than 0.5 and 3.0 or less.

According to the water-soluble adhesive composition for component capture of the present invention, a water-soluble adhesive having a weight-average molecular weight of 1.0 × 10⁴ or more and 1.0 × 10⁶ or less is contained at a predetermined ratio. It is thus possible to improve impact absorption and the stickiness and adhesiveness of the water-soluble adhesive composition for component capture, and reduce damage or misalignment of a component (element) particularly in the production of an electronic component.

In the water-soluble adhesive composition for component capture according to the aspect of the present invention, the (A) water-soluble adhesive preferably contains at least one kind of water-soluble adhesive selected from the group consisting of a vinyl alcohol-based polymer, a vinylpyrrolidone-based polymer, an acrylic polymer, and saccharide.

According to the above aspect, it is possible to provide a water-soluble adhesive composition for component capture which is superior in tackiness and stickiness and superior also in washing with water.

In the water-soluble adhesive composition for component capture according to the aspect of the present invention, the (B) water-soluble plasticizer is preferably a monohydric or polyhydric alcohol of a liquid at normal temperature (25°C).

According to the above aspect, it is possible to provide a water-soluble adhesive composition for component capture which is superior in compatibility with the water-soluble adhesive, superior in tackiness and stickiness, and superior also in washing with water.

In the water-soluble adhesive composition for component capture according to the aspect of the present invention, the (B) water-soluble plasticizer preferably has a boiling point of 120°C or higher.

According to the above aspect, it is possible to provide a water-soluble adhesive composition for component capture which is less likely to evaporate and less likely to change in physical properties in a bonding process involving applying heat and/or pressure after capturing a component.

In the water-soluble adhesive composition for component capture according to the aspect of the present invention, the (B) water-soluble plasticizer preferably contains at least one kind selected from glycerin, diglycerin, polyethylene glycol, ethylene glycol, propylene glycol, and polypropylene glycol.

According to the above aspect, Glycerin, diglycerin, polyethylene glycol, ethylene glycol, propylene glycol, and polypropylene glycol all have high boiling points and are thus unlikely to evaporate during the bonding process involving applying heat and/or pressure. It is therefore possible to reduce the formation of vapor bubbles (so-called "voids") in the composition. **In** addition, they are superior in washing with water.

According to an aspect of the present invention, a water-soluble adhesive sheet for component capture is provided which includes a layer as a sheet made of the water-soluble adhesive composition for component capture described above.

According to the water-soluble adhesive sheet for component capture of the present invention, the water-soluble adhesive composition for component capture formed into a sheet provides superior impact absorption and superior stickiness and adhesiveness, as well as superior handling in attachment and peeling, thereby making it possible to improve work efficiency relating to component capturing. Further, since the water-soluble adhesive sheet for component capture contains a much smaller amount of the liquid component, it is possible to increase the transportation efficiency and storage stability.

According to an aspect of the present invention, a method for producing an electronic component is provided which includes capturing a component using the water-soluble adhesive composition for component capture described above.

According to the method for producing an electronic component of the present invention, since the water-soluble adhesive composition for component capture superior in the impact absorption and the stickiness and adhesiveness is used, it is possible to effectively reduce damage or a rebound of a component (element) due to collision with a transfer target member in the transfer process and effectively prevent fault in capturing (mounting) a component (element) at a desired position. Thus, high-precision, efficient production of electronic components is possible.

According to an aspect of the present invention, a method for producing an electronic component is provided which includes capturing a component using the water-soluble adhesive sheet for component capture described above.

According to the method for producing an electronic component of the present invention, since water-soluble adhesive sheet for component capture superior in the impact absorption and the stickiness and adhesiveness is used, it is possible to effectively reduce damage or a rebound of a component (element) due to collision with a transfer target member in the transfer process and effectively prevent fault in capturing (mounting) a component (element) at a desired position. Since the water-soluble adhesive sheet for component capture superior in handing in attachment and peeling is used, operations related to capturing and operations related to removing residues after capturing are effectively made easy in producing electronic components. Thus, high-precision, efficient production of electronic components is possible.

### ADVANTAGES OF THE INVENTION

According to the present invention, it is possible to provide a water-soluble adhesive composition for component capture and a water-soluble adhesive sheet for component capture which are superior in the impact absorption and the stickiness and adhesiveness and also superior in handling in attachment and peeling and which are suitable for capturing components, and provide a method which allows high-precision, efficient production of electronic components, by using the water-soluble adhesive composition for component capture and the water-soluble adhesive sheet for component capture.

### BRIEF DESCRIPTION OF THE DRAWINGS

[FIG. 1] FIG. 1 is a schematic diagram illustrating a non-contact transfer process, which is an example of a component capturing process using a water-soluble adhesive composition for component capture (a water-soluble adhesive sheet for component capture) of the present invention.
[FIG. 2] FIG. 2 is a schematic diagram illustrating a contact transfer process, which is an example of a component capturing process using a water-soluble adhesive composition for component capture (a water-soluble adhesive sheet for component capture) of the present invention.

### DESCRIPTION OF EMBODIMENT

### [Water-Soluble Adhesive Composition For Component Capture And Water-Soluble Adhesive Sheet For Component Capture]

The water-soluble adhesive composition for component capture and the water-soluble adhesive sheet for component capture of the present invention are used for capturing components. Moreover, they are removable after capturing by washing with water. The purpose of using the water-soluble adhesive composition for component capture and the water-soluble adhesive sheet for component capture of the present invention is not particularly limited, and may include, for example, capturing an electronic component on a substrate in the production of the electronic component. The electronic component to be captured may be an element or part of that element selected from a semiconductor element, a liquid crystal element, a photoelectric conversion element, a piezoelectric element, a thin film transistor element, a thin film diode element, a resistance element, a switching element, a micro magnetic element, and a micro optical element; or a combination of these elements.

The water-soluble adhesive composition for component capture and the water-soluble adhesive sheet for component capture of the present invention will be described below on the assumption that mainly a semiconductor element is captured on a substrate, but are not limited thereto.

In the following description, the water-soluble adhesive composition for component capture of the present invention will be simply referred to as a "capturing composition" and also the water-soluble adhesive sheet for component capture as a "capturing sheet."

For example, the water-soluble adhesive composition for component capture and the water-soluble adhesive sheet for component capture of the present invention provide impact absorption for receiving semiconductor elements, such as LED elements, separated from a transfer source substrate by energy beams (e.g., lasers) or the like, and also provide stickiness and tackiness for capturing the received semiconductor elements in desired positions on a substrate, and stickiness and adhesiveness with the substrate. Further, residues of the water-soluble adhesive composition for component capture and the water-soluble adhesive sheet for component capture of the present invention can be dissolved in water and removable in the washing process.

The water-soluble adhesive composition for component capture of the present invention can be in liquid form. However, the water-soluble adhesive composition for component capture may be formed into a layer as a sheet so that the water-soluble adhesive sheet for component capture includes this layer. The water-soluble adhesive sheet for component capture can eliminate the application of the composition to a wiring substrate and a drying process and can be handled more easily, as compared to the water-soluble adhesive composition for component capture, thereby making it possible to improve work efficiency. Further, since the water-soluble adhesive sheet for component capture contains a much smaller amount of the liquid component than the water-soluble adhesive composition for component capture, it is possible to increase the transportation efficiency and storage stability.

Moreover, the attachment of the sheet makes a flatter surface where components are to be captured (mounted) as compared to the application of the water-soluble adhesive composition for component capture in liquid form. It is thus possible to place the components stably on the water-soluble adhesive sheet for component capture of the present invention.

The shape of the water-soluble adhesive sheet for component capture of the present invention is not particularly limited. The shape of the water-soluble adhesive sheet for component capture of the present invention may be, for example, a polygon (e.g., a rectangle, a rectangle-shaped, a triangle, etc.), a circle, an ellipse, an irregular shape, etc., when viewed from above. The water-soluble adhesive sheet for component capture of the present invention can have a desired shape, such as a shape that corresponds to the shape of a substrate to which the sheet is to be attached. The sheet of the present invention may be formed into a desired shape by a known technique such as cutting. The sheet of the present invention may be wound into a roll, and a necessary amount may be cut out for use.

The thickness of the water-soluble adhesive sheet for component capture of the present invention is not particularly limited and preferably 1 µm or more, more preferably 3 µm or more, and even more preferably 5 µm or more, for example.

It is preferable that the thickness of the water-soluble adhesive sheet for component capture of the present invention is 1 µm or more because the impact absorption improves.

The upper limit of the thickness of the water-soluble adhesive sheet for component capture of the present invention is preferably 500 µm or less, more preferably 100 µm or less, and even more preferably 50 µm or less.

It is preferable that the thickness of the water-soluble adhesive sheet for component capture of the present invention is 500 µm or less, because fewer residues are left and it is possible to shorten a time of the washing process for sheet removal.

It is preferable that the thickness of the water-soluble adhesive sheet for component capture of the present invention is selected appropriately in relation to the height of a bump formed on the semiconductor element. If the thickness of the capturing sheet is greater than the height of the bump, the bottom and side surfaces of the semiconductor element are in contact with the capturing sheet. It is thus possible to reduce a rebound of the semiconductor element.

The water-soluble adhesive composition for component capture and the water-soluble adhesive sheet for component capture of the present invention contain a water-soluble plasticizer (B). If this water-soluble plasticizer (B) is a liquid component and is contained in a higher ratio, particularly the upper surface of the capturing sheet gets wet easily on the side surface of the bump of the semiconductor element and the side surface of the semiconductor element, in an early stage of a rebound of the semiconductor element after it sinks. The surface tension and sticking force due to this wetting effectively reduce a rebound of the semiconductor element and damage to the semiconductor element.

If the semiconductor element sinks deep into the capturing sheet, the upper surface of the semiconductor element is covered with the capturing sheet, resulting in a much greater resistance against the rebound; therefore, misalignment is smaller even if a process relating to the capture of the semiconductor element is performed at high speed.

That is, the rebound reduction effect on the semiconductor element increases in the following order in the early stage of the rebound: "the capturing sheet is wet on the side surface of the bump of the semiconductor element (wet at the bump of the semiconductor element);" "the capturing sheet is wet on the side surface of the semiconductor element (wet at the bump of the semiconductor element, the bottom surface of the semiconductor element, and the side surface of the semiconductor element);" and "the upper surface of the semiconductor element is covered with the capturing sheet (wet at the bump of the semiconductor element, the bottom surface of the semiconductor element, the side surface of the semiconductor element, and the upper surface of the semiconductor element)."

A ratio between the thickness of the water-soluble adhesive sheet for component capture of the present invention and the height of the bump of the semiconductor element (thickness of the sheet/height of the bump) is preferably 1.0 or more, more preferably 1.2 or more, and even more preferably 1.5 or more, from the viewpoint of misalignment at the capture of the semiconductor element and damage of the semiconductor element. It is preferable that the ratio between the thickness of the water-soluble adhesive sheet for component capture of the present invention and the height of the bump is 1.0 or more, because misalignment of the bump of the semiconductor element from the desired position of the electrode on the substrate in the process of capturing the semiconductor element is less likely to occur.

In a bonding process involving applying heat and/or pressure after the capture of the semiconductor element without misalignment, the semiconductor element needs to sink (again) due to softening of the capturing sheet so that the bump of the semiconductor element and the substrate electrode come into contact with each other. Thus, if the thickness of the capturing sheet is much greater than the height of the semiconductor element (the shortest distance between the lower surface of the bump of the semiconductor element and the upper surface of the semiconductor element), the distance of the (re)sinking of the semiconductor element is longer, which may lead to wobbling of the semiconductor element during the sinking and greater misalignment from the substrate electrode.

Accordingly, the ratio between the thickness of the water-soluble adhesive sheet for component capture of the present invention and the height of the bump (thickness of the capturing sheet/height of the bump of the semiconductor element) is preferably 5.0 or less, more preferably 3.6 or less, and even more preferably 2.3 or less, from the viewpoint of misalignment due to sinking of the semiconductor element in the bonding process after the capture of the semiconductor element without misalignment. If the ratio between the thickness of the water-soluble adhesive sheet for component capture of the present invention and the height of the bump of the semiconductor element is 3.0 or less, it is possible to reduce misalignment of the bump of the semiconductor element with the substrate electrode due to the sinking in the bonding process after the capture of the semiconductor element in the desired position.

The height of the bump formed on the semiconductor element is not particularly limited and 1 µm or more and 50 µm or less, for example. The lower limit of the height of the bump is preferably 1 µm or more, more preferably 2 µm or more, and even more preferably 3 µm or more. The upper limit of the height of the bump is preferably 50 µm or less, more preferably 30 µm or less, and even more preferably 20 µm or less.

The water-soluble adhesive composition for component capture and the water-soluble adhesive sheet for component capture of the present invention contain an (A) water-soluble adhesive and a (B) water-soluble plasticizer.

The content of the component (A) is, for example, 10% by mass or more and 65% by mass or less with respect to the entirety of the capturing sheet. The component (A) of 10% by mass or more is preferred in terms of formability of the sheet. The component (A) of 65% by mass or less is preferred in terms of the stickiness and adhesiveness.
The lower limit of the content of the component (A) is preferably 20% by mass or more, more preferably 25% by mass or more, and even more preferably 30% by mass or more from the viewpoint of improvement in the formability of the sheet.

The upper limit of the content of the component (A) is preferably 65% by mass or less, more preferably 60% by mass or less, and even more preferably 55% by mass or less from the viewpoint of stickiness and adhesiveness.

The content of the component (B) is, for example, preferably 35% by mass or more, more preferably 40% by mass or more, and even more preferably 50% by mass or more with respect to the entirety of the capturing sheet.

The content of the component (B) of 35% by mass or more is preferred because it prevents the misalignment of the semiconductor element in a transfer process more from the viewpoint of the sticking force, adhesive force, surface tension, and rheological properties. By setting the content of the component (B) to be in the above range, the characteristics as a liquid is enhanced, and the wettability to the semiconductor element is improved. It is thus possible to reduce a rebound of the semiconductor element. In the above range, polymer chains of the water-soluble adhesive can move easily, which provides superior impact absorption. The impact absorption is found superior also from the fact that according to the frequency-dependent rheological properties, as the frequency increases, the value of the storage modulus G' (E'), which is the elastic term, is substantially constant, while the loss modulus G" (E"), which is the viscous term, tends to increase, and as a result, the tan δ, which is an index of impact absorption, increases.

The content of the component (B) is preferably 300% by mass or less, more preferably 250% by mass or less, and even more preferably 200% by mass or less with respect to the component (A).

The content of the component (B) of 300% by mass or less is preferred from the viewpoint of formability of the sheet.

Components constituting the water-soluble adhesive composition for component capture and the water-soluble adhesive sheet for component capture of the present invention will be described below.

### [(A) Water-Soluble Adhesive]

The water-soluble adhesive that is the component (A) is a main component constituting the capturing composition and the capturing sheet, and contains a polymer as a main constituent component. The water-soluble adhesive, i.e., the component (A), is a component having water solubility and is a component that exhibits stickiness when used alone or when a water-soluble plasticizer is added thereto.

Here, the "water-soluble" means dissolving without turbidity when made into a 1% by mass aqueous solution under normal temperature (25°C). The "stickiness" means that when a sheet (1 cm × 5 cm × 10 µm) made of the water-soluble adhesive that is the component (A) alone or made by adding 30 parts by mass or 50 parts by mass of the water-soluble plasticizer that is the component (B) is pressed against, for example, a PET film (non-release treatment surface) at normal temperature (25°C), and the PET film with the sheet attached thereto is cut into a strip and hung vertically, the sheet will not come off immediately from the PET film.

Since containing the component (A), the water-soluble adhesive composition for component capture and the water-soluble adhesive sheet for component capture of the present invention provide the improved tackiness and stickiness (pressure-sensitive adhesiveness) to the semiconductor element, improved stickiness and adhesiveness to the substrate, reduced decomposition or improved meltability in applying heat and/or pressure in the bonding process, and moreover improved water solubility.

The polymer constituting the component (A) encompasses those polymers which themselves have the tackiness and stickiness, and those which exhibit the tackiness and stickiness in the gel form.

It is preferable that the water-soluble adhesive composition for component capture and the water-soluble adhesive sheet for component capture of the present invention melt in the bonding process involving applying heat and/or pressure to electrically connect the substrate and the semiconductor element, so that the bump of the semiconductor element and the electrode of the substrate are brought into conduction. In this case, it is preferable to use a polymer that melts at a temperature in the bonding process as the polymer constituting the component (A). At this time, the softening point of the polymer constituting the component (A) is not particularly limited as long as the capturing composition or the capturing sheet melts in the bonding process.

For example, a case is considered in which the ratio (B/A) of the content of the (B) water-soluble plasticizer to the content of the (A) water-soluble adhesive in the capturing composition or the capturing sheet decreases significantly due to evaporation or the like of the (B) water-soluble plasticizer (liquid component) during the bonding process. In this case, the softening point of the polymer constituting the component (A) is preferably 200°C or lower, more preferably 150°C or lower, even more preferably 100°C or lower, and far more preferably 80°C or lower from the viewpoint of causing sinking of the semiconductor element into the capturing composition or the capturing sheet due to softening of the (A) water-soluble adhesive even if the (B) water-soluble plasticizer has vanished during the bonding process.

On the other hand, for example, the softening point of the polymer constituting the component (A) is preferably 40°C or higher, more preferably 100°C or higher, even more preferably 150°C or higher, and far more preferably 200°C or higher from the viewpoint of the ability to make it into a sheet even at a higher content of the (B) water-soluble plasticizer.

The polymer constituting the component (A) dissolves in water, and therefore can be easily removed from the substrate by washing with water after the bonding process.

The solubility of the polymer constituting the component (A) is not particularly limited as long as the polymer can be cleaned with water. For example, the solubility in water of the polymer constituting the component (A) at 90°C is preferably 0.05 g/g-H₂O or higher, more preferably 0.10 g/g-H₂O or higher, and even more preferably 0.30 g/g-H₂O or higher.

A value of 0.05 g/g-H₂O or higher is preferred because it allows for quick cleaning even at normal temperature and eliminates or extremely reduces cleaning residues.

If the weight-average molecular weight of the component (A) exceeds 1.0 × 10⁶, for example, a longer time is needed in order that the component (A) is dissolved in water for washing, which results in leaving more cleaning residues. It is thus preferable to increase the dissolution rate of the component (A) by decomposing the component (A) to a lower molecular weight, from the viewpoint of reducing the cleaning time and the cleaning residues. The method for reducing the molecular weight is not particularly limited as long as the method does not cause damage to a workpiece such as a semiconductor element and a substrate. For example, if the component (A) is a natural polymer, various known hydrolases can be used.

For example, if the component (A) contains a polymer of α-glucose, such as starch and pullulan, or/and a derivative thereof, hydrolases such as amylase, glucoamylase, and pullulanase can be used. For example, in the case of natural polymers containing a polymer of β-glucose, such as carboxymethyl cellulose (CMC), or/and a derivative thereof, cellulase and the like can be used. For example, in the case of natural polymers derived from amino acids such as silk, protease and the like can be used. In using these hydrolases, it is preferable to perform cleaning in the optimum pH and temperature range for exhibiting high enzymatic activity, and it is possible, depending on the enzyme, to further increase the enzymatic activity by the addition of an additive such as Ca²⁺.

The weight-average molecular weight Mw of the polymer constituting the component (A) is preferably 1.0 × 10⁴ or more, more preferably 5.0 × 10⁴ or more, and even more preferably 1.0 × 10⁵ or more from the viewpoint of the improvement in the formability of the sheet. If the weight-average molecular weight Mw of the polymer constituting the component (A) exceeds, for example, 1.0 × 10⁶, it is preferable to increase the dissolution rate of the component (A) in water by decomposing the component (A) to a lower molecular weight by hydrolysis or other methods, from the viewpoint of reducing the cleaning time and the cleaning residues, as described above.

Further, the weight-average molecular weight Mw of the polymer constituting the component (A) is preferably 1.0 × 10⁶ or less, more preferably 8.0 × 10⁵ or less, and even more preferably 4.0 × 10⁵ or less from the viewpoint of sinking of the semiconductor element into the capturing composition (or the capturing sheet) due to softening of the water-soluble adhesive, and the viewpoint of cleaning with water.

The molecular weight distribution Mw/Mn (where Mn represents a number average molecular weight) of the polymer constituting the component (A) is not particularly limited. For example, the lower limit of the molecular weight distribution Mw/Mn is preferably 1.5 or more and more preferably 1.8 or more.

The upper limit of the molecular weight distribution Mw/Mn is preferably 30 or less, more preferably 15 or less, and even more preferably 8 or less.

By setting the molecular weight distribution Mw/Mn to be in the above range, it is possible to form a favorable sheet with reduced property variations in the sheet and more uniform properties.

### <Vinyl Alcohol-Based Polymer>

In the present invention, the vinyl alcohol-based polymer refers to a polymer having repeat units of hydroxyethylene represented by the general formula (1).

Hereinafter, the structure represented by the general formula (1) will also be referred to as a vinyl alcohol repeat unit.

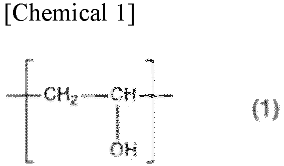

The vinyl alcohol-based polymer may have a homopolymer structure in which the repeat unit consists of only vinyl alcohol repeat unit, or may have a copolymer structure with another repeat unit.

Hereinafter, the vinyl alcohol-based polymer having a homopolymer structure in which the repeat unit consists of only vinyl alcohol repeat unit will also be referred to simply as "homopolymer," and the vinyl alcohol-based polymer having a copolymer structure with another repeat unit simply as "copolymer."

In general, the vinyl alcohol-based polymer is produced by homopolymerizing or copolymerizing a monomer (for example, vinyl acetate) in which the hydroxyl group of vinyl alcohol is protected, followed by modification (for example, hydrolysis) to eliminate the protecting group.

Accordingly, examples of the repeat unit other than the vinyl alcohol repeat unit include units with remaining repeat units before modification. Examples of the repeat unit before modification include, for example, repeat units derived from vinyl formate, vinyl acetate, vinyl propionate, vinyl butyrate, vinyl isobutyrate, vinyl pivalate, vinyl versatate, vinyl caproate, vinyl caprylate, vinyl laurate, vinyl palmitate, vinyl stearate, vinyl oleate, vinyl trifluoroacetate, vinyl benzoate, butyl vinyl ether and trimethylsilyl vinyl ether.

Hereinafter, those repeat units in the vinyl alcohol-based polymer which are not modified and have remaining functional groups before modification will also be referred to as "unmodified repeat unit."

The unmodified repeat unit remaining in the vinyl alcohol-based polymer may be of one type or two or more types.

In general, the vinyl alcohol-based polymer is produced by saponifying a vinyl acetate-based polymer. Thus, a vinyl alcohol-based copolymer obtained through modification of a vinyl acetate polymer and the repeat unit before modification of which is derived from vinyl acetate which is readily available, is preferably used.

The solubility in water and stickiness (pressure-sensitive adhesiveness) of a vinyl alcohol-based polymer consisting of vinyl alcohol repeat units and unmodified repeat units are affected by the degree of saponification and the degree of polymerization.

Here, the degree of saponification of the vinyl alcohol-based polymer consisting of vinyl alcohol repeat units and unmodified repeat units is a ratio of the vinyl alcohol repeat units to the entire repeat units (a ratio expressed by [the number of vinyl alcohol repeat units] / {[the number of vinyl alcohol repeat units] + [the number of unmodified repeat units]}).

The solubility in water of the vinyl alcohol-based polymer consisting of vinyl alcohol repeat units and unmodified repeat units decreases when the degree of saponification is too high or too low. The solubility in water also decreases when the degree of polymerization is high.

Thus, the degree of saponification and the degree of polymerization of the vinyl alcohol-based polymer consisting also of the unmodified repeat units are determined depending on the type of the unmodified repeat units.

For example, the lower limit of the degree of saponification is preferably 30% or more, more preferably 40% or more, and even more preferably 50% or more.

For example, the upper limit of the degree of saponification is preferably 90% or less, more preferably 80% or less, and even more preferably 70% or less.

Within the above range, the vinyl alcohol-based polymer is prevented from being difficult to dissolve in water due to crystallization or being difficult to dissolve in water due to fewer hydrophilic groups, and therefore preferably used.

The vinyl alcohol-based polymer may include one type or two or more types of repeat unit other than the vinyl alcohol repeat units and the unmodified repeat units. Examples of the repeat unit other than the vinyl alcohol repeat units and the unmodified repeat units include, for example, repeat units derived from ethylene, (meth)acrylic acid, maleic acid, vinylpyrrolidone, aminoalkyl ester of (meth)acrylic acid, a monomer represented by the general formula (2) (such as oxyethylene monoallyl ether and ethyl carbitol (meth) acrylate), etc.

Hereinafter, those repeat units other than the vinyl alcohol repeat units and the unmodified repeat unit will also be referred to as "third repeat unit."

The degree of saponification can be measured by ¹H-NMR if a third repeat unit (such as oxyalkylene structure) is present, or measured in accordance with JIS K 6726 if the third repeat unit is not present. 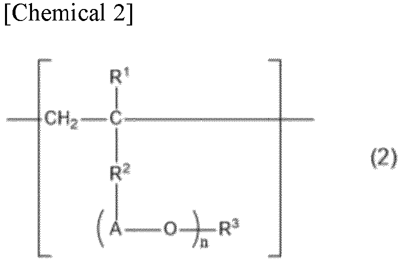 (where R¹ and R³ independently represent a hydrogen atom or an organic group; R² represents an ether bond, an ester bond, an amide bond, an alkylene having 1 to 6 carbon atoms or a composite group of these, or a single bond; A represents an alkylene group having 2 to 22 carbon atoms; and n is an integer of 1 or more.)

R¹ in the general formula (2) represents a hydrogen atom or an organic group having 1 to 20 carbon atoms, and the organic group may naturally contain one kind or two or more kinds of the following elements: O, N, S, Si, and P.

Examples of the organic group represented by R¹ include, for example, an alkyl group, an acyl group, an acyloxy group, an alkoxycarbonyl group, an alkyl ester group (an acyloxy-substituted hydrocarbyl group and an alkoxycarbonyl-substituted hydrocarbyl group), an alkylamidoalkylene group, and a sulfonate group.

Examples of the alkyl group include, for example, a methyl group, an ethyl group, an n-propyl group, an i-propyl group, a butyl group, a pentyl group, a hexyl group, etc.

Examples of the acyl group include a methylcarbonyl group, an ethylcarbonyl group, an n-propylcarbonyl group, an i-propylcarbonyl group, a butylcarbonyl group, a pentylcarbonyl group, a hexylcarbonyl group, etc.

Examples of the alkyl ester group include a methyloxycarbonylmethylene group, a methylcarbonyloxymethylene group, an ethyloxycarbonylethylene group, an ethylcarbonyloxyethylene group, etc.

Examples of the alkylamidoalkylene group include an N,N'-dimethylamidoalkylene group, an N,N'-diethylamidoalkylene group, etc.

R¹ is preferably a hydrogen atom or any one of an alkyl group, an acyl group, an alkyl ester group, or alkylamidoalkylene group having 1 to 10 carbon atoms, more preferably a hydrogen atom or a methyl group, and even more preferably a hydrogen atom.

R¹ is preferably a hydrogen atom because the glass transition temperature of the polymer can be lowered.

R² in the general formula (2) represents an ether bond (-O-), an ester bond (-COO-, - OCO-), an amide bond (-NHCO-, -OCNH-), alkylene having 1 to 6 carbon atoms or a composite group of these, or a single bond.

R³ in the general formula (2) represents a hydrogen atom or an organic group having 1 to 20 carbon atoms, and the organic group may naturally contain one kind or two or more kinds of the following elements: O, N, S, Si, and P.

Examples of the organic group represented by R³ include, for example, an alkyl group, an acyl group, an alkoxycarbonyl group, an alkyl ester group (an acyloxy-substituted hydrocarbyl group and an alkoxycarbonyl-substituted hydrocarbyl group), an alkylamide group, an alkylamidoalkylene group, and a sulfonate group.

Examples of the alkyl group include, for example, a methyl group, an ethyl group, an n-propyl group, an i-propyl group, a butyl group, a pentyl group, a hexyl group, etc.

Examples of the acyl group include a methylcarbonyl group, an ethylcarbonyl group, an n-propylcarbonyl group, an i-propylcarbonyl group, a butylcarbonyl group, a pentylcarbonyl group, a hexylcarbonyl group, etc.

Examples of the alkyl ester group include a methyloxycarbonylmethylene group, a methylcarbonyloxymethylene group, an ethyloxycarbonylethylene group, an ethylcarbonyloxyethylene group, etc.

Examples of the alkylamidoalkylene group include an N,N'-dimethylamidoalkylene group, an N,N'-diethylamidoalkylene group, etc.

R³ is preferably a hydrogen atom or any one of an alkyl group, an acyl group, an alkyl ester group, or alkylamidoalkylene group having 1 to 10 carbon atoms, and more preferably a hydrogen atom or a methyl group.

A in the general formula (2) represents a linear or branched alkylene group having 2 to 22 carbon atoms.

**In** the general formula (2), when n is 2 or more, a plurality of A may be the same or different from each other.

The number of carbon atoms of A in the general formula (2) is preferably 10 or less, more preferably 4 or less, even more preferably 3 or less, and particularly preferably 2.

Examples of A in the general formula (2) include, for example, dimethylene (ethylene), trimethylene, methylethylene, tetramethylene, 1-methylpropylene, 2-methylpropylene, **1-**ethylethylene, etc.

**In** the oxyalkylene structure, an oxyalkylene group having a smaller number of carbon atoms in the alkylene group acting as a hydrophobic group is more hydrophilic than an oxyalkylene group having a larger number of carbon atoms.

Therefore, in the general formula (2), the oxyalkylene structure represented by "AO" is most preferably an oxyethylene structure.

The number of repeat units n in the general formula (2) represents the number of oxyalkylene structures represented by "AO" which is a hydrophilic group. Thus, in general, as the number of n increases, the hydrophilicity of the repeat unit represented by the general formula (2) increases.

Accordingly, the lower limit of the number of repeat units n in the general formula (2) is preferably 2 or more, more preferably 5 or more, and even more preferably 6 or more. The upper limit of the number of repeat units n in the general formula (2) is preferably 300 or less, more preferably 200 or less, even more preferably 65 or less, and particularly preferably 20 or less.

By setting the number of repeat units n of the oxyalkylene group to be in the above range, it is possible to improve solubility in water at low temperatures and improve the stickiness as well.

The content ratio of the third repeat unit is not particularly limited as long as the vinyl alcohol-based polymer exhibits tackiness and stickiness (pressure-sensitive adhesiveness) and can dissolve in water.

Thus, the ratio of the third repeat unit is determined depending on the type of the third repeat unit from the viewpoint of tackiness and stickiness (pressure-sensitive adhesiveness) and water solubility.

For example, the ratio of the third repeat unit in the vinyl alcohol-based polymer ("third repeat unit" × 100 / "vinyl alcohol repeat unit" + "unmodified repeat unit" + "third repeat unit") is preferably 0.5 mol% or more, more preferably 3.0 mol% or more, and even more preferably 5.0 mol% or more.

If the ratio is 0.5 mol% or more, the solubility in water at low temperatures and the miscibility with the (B) water-soluble plasticizer are good; therefore, the vinyl alcohol-based polymer can be preferably used.

Further, the ratio of the third repeat unit in the vinyl alcohol-based polymer is preferably 20 mol% or less, more preferably 10 mol% or less, and even more preferably 5 mol% or less.

If the ratio is 20 mol% or less, the formability of the sheet is good; therefore, the vinyl alcohol-based polymer can be preferably used.

The content ratio of the vinyl alcohol repeat units in the vinyl alcohol-based polymer is not particularly limited as long as the vinyl alcohol-based polymer exhibits stickiness (pressure-sensitive adhesiveness) and can dissolve in water. For example, the ratio of the vinyl alcohol repeat unit in the vinyl alcohol-based polymer is preferably 20 mol% or more, more preferably 30 mol% or more, and even more preferably 40 mol% or more.

The ratio of 20 mol% or more is preferred because the stickiness is good.

Further, the ratio of the vinyl alcohol repeat unit in the vinyl alcohol-based polymer is preferably 90 mol% or less, more preferably 80 mol% or less, and even more preferably 60 mol% or less.

The ratio of 90 mol% or less is preferred because the stickiness is good.

Among vinyl alcohol-based polymers, polymers containing repeat units derived from monomers having a (poly)oxyalkylene structure have increased water solubility.

Thus, a repeat unit derived from a monomer having a (poly)oxyalkylene structure is preferred as the third repeat unit.

If the third repeat unit is soluble in water, the water solubility of the vinyl alcohol-based polymer can be improved without depending on the vinyl alcohol repeat unit. Thus, from the viewpoint of solubility in water, the degree of saponification of the vinyl alcohol-based polymer can be lower than the degree of saponification of the vinyl alcohol-based polymer not containing the third repeat unit.

Further, as a result of a lower ratio of the crystalline vinyl alcohol repeat units, the glass transition temperature of the vinyl alcohol-based copolymer can be lowered and the tackiness and stickiness can be improved.

Thus, the third repeat unit is more preferably a repeat unit derived from a monomer having a (poly)oxyalkylene structure, and even more preferably the repeat unit represented by the general formula (2).

The homopolymer of vinyl alcohol or vinyl alcohol-based copolymer may have a structure represented by the general formula (3) at least at one end of the polymer. 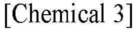 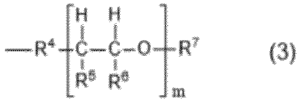 (where R⁴ represents an ether bond, an ester bond, an amide bond, an alkylene having 1 to 6 carbon atoms or a composite group of these, or a single bond; R⁵ and R⁶ independently represent a hydrogen atom or an alkyl group having 1 to 10 carbon atoms; R⁷ represents a hydrogen atom or an organic group having 1 to 20 carbon atoms; and m is an integer of 1 or more.)

R⁴, R⁷ and m in the general formula (3) are the same as those described for R², R³ and n in the general formula (2), respectively.

R⁵ and R⁶ are each independently a hydrogen atom or an alkyl group having 1 to 10 carbon atoms. When m is 2 or more, a plurality of R⁵ or a plurality of R⁶ may be the same or different.

Examples of the alkyl group as R⁵ and R⁶ include, for example, a methyl group, an ethyl group, an n-propyl group, an i-propyl group, a butyl group, a pentyl group, a hexyl group, etc.

Hydrogen atoms are preferred from the viewpoint of improving the water solubility of the vinyl alcohol-based polymer.

As the vinyl alcohol-based polymer, one type of polymer selected from homopolymers of vinyl alcohol, vinyl alcohol-based copolymers, and vinyl alcohol-based polymers having a structure represented by the general formula (3) at least at one end may be used alone, or two or more types thereof may be used. Two or more types may be two or more types selected from the vinyl alcohol-based copolymers, or two or more types selected from the vinyl alcohol-based polymers having a structure represented by the general formula (3) at least at one end.

### <Vinylpyrrolidone-Based Polymer>

In the present invention, the vinylpyrrolidone-based polymer refers to a polymer having a structure represented by the general formula (4) as a main repeat unit.

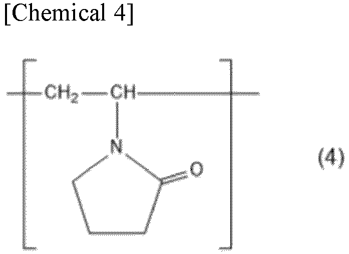

The vinylpyrrolidone-based polymer may be a homopolymer of vinylpyrrolidone or may be a copolymer.

Examples of the copolymerization component include, for example, ethylene, (meth)acrylic acid, maleic acid, vinylpyrrolidone, aminoalkyl ester of (meth)acrylic acid, a monomer represented by the general formula (2) (such as oxyethylene monoallyl ether and ethyl carbitol (meth) acrylate), etc.

The ratio of the copolymerization component in the vinylpyrrolidone-based polymer is not particularly limited as long as the effect of the present invention is not impaired. For example, the ratio of the copolymerization component is preferably 30 mol% or less, more preferably 10 mol% or less, and even more preferably 5 mol% or less.

The ratio of 30 mol% or less is preferred because the formation of a strong hydrogen bond with water accompanied by heat generation is not inhibited and the solubility in water is good.

Vinylpyrrolidone is particularly useful and preferred due to its ease of availability and superiority in water solubility and stickiness.

### <Acrylic Polymer>

The acrylic polymer refers to a polymer having, as a main repeat unit, a structure through addition polymerization of a monomer having a (meth)acryloyloxy structure.

The water-soluble acrylic polymer preferably has a hydroxyl group, a carboxyl group (including a functional group of a salt of a carboxyl group, such as sodium carboxylate and ammonium carboxylate), an oxyalkylene group (for example, an oxyethylene structure or an oxypropylene structure), or an amino group (including a functional group of a salt of an amino group, such as ammonium hydrochloride or ammonium sulfate).

The acrylic polymer more preferably has a hydroxyl group or an oxyalkylene group because the water solubility is improved.

Since having stickiness (pressure-sensitive adhesiveness) by itself or by containing the (B) water-soluble plasticizer, the acrylic polymer used in the present invention has a glass transition temperature that is preferably 120°C or lower, more preferably 80°C or lower, and even more preferably 50°C or lower.

The glass transition temperature was measured in accordance with JIS K 6240 (DSC method).

Examples of the acrylic polymer include, for example, copolymers obtained through copolymerization of one type or two or more types selected from hydrophilic acrylic acid-based monomers (acrylic acid, carboxyethyl acrylate, hydroxyethyl acrylate, 2-(2-ethoxyethoxy)ethyl acrylate, polyoxyethylene acrylate, polyoxypropylene acrylate, polyoxyethylene polyoxypropylene acrylate, etc.) and one type or two or more types selected from acrylates (methyl acrylate, ethyl acrylate, propylene acrylate, butyl acrylate, 2-ethylhexyl acrylate, etc.), methacrylic monomers (methacrylic acid, methacrylates, hydroxy methacrylates, poly(oxyalkylene) methacrylates, etc.) and acrylonitrile.

The ratio of monomers other than the hydrophilic acrylic acid-based monomers in the acrylic polymer is not particularly limited as long as the acrylic polymer can dissolve in water and the glass transition temperature is preferably 120°C or lower. For example, the ratio of the monomers is preferably 30 mol% or less, more preferably 10 mol% or less, and even more preferably 5 mol% or less.

Examples of the acrylic polymer include, for example, a copolymer obtained through copolymerization of hydrophilic acrylic acid-based monomers that form a homopolymer having a low glass transition temperature in combination with a (meth)acrylic acid-based monomer and a (meth)acrylate which have a polar group (carboxyl group and hydroxyl group) or the like that improves the stickiness (pressure-sensitive adhesiveness) to a metal.

### <Saccharide>

**In** the present invention, the saccharide refers to a polymer having the characteristics of the water-soluble adhesive described above.

For example, the saccharide may be pullulan which is a repeat unit represented by the general formula (5), hydroxyethyl cellulose which is a repeat unit represented by the general formula (6), carboxymethyl cellulose which is a repeat unit represented by the general formula (7), starch, etc. 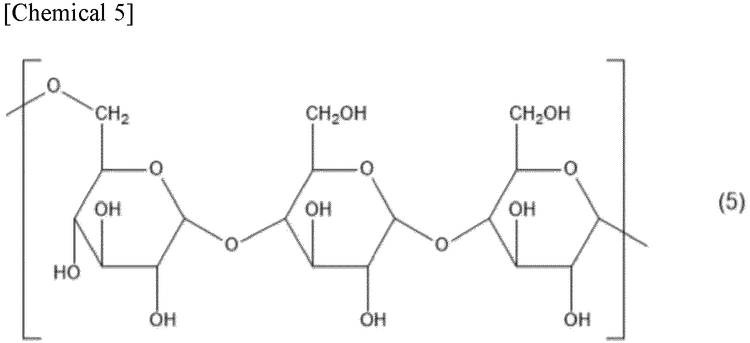 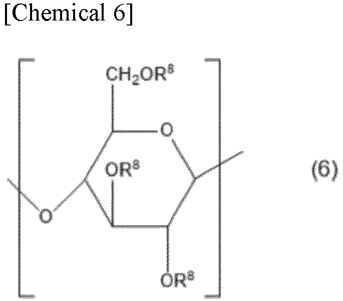 (where R⁸ independently represents a hydrogen atom or a mono or poly-oxyalkylene group having a hydrogen atom at an end.) 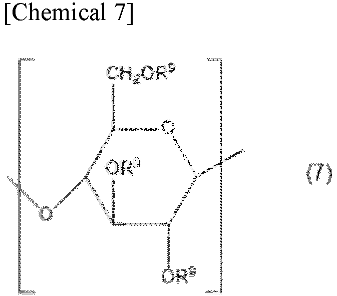 (where R⁹ independently represents a hydrogen atom or CH₂COONa or CH₂COONH₄.)

### [(B) Water-Soluble Plasticizer]

The water-soluble plasticizer that is the component (B) acts as a plasticizer of the component (A) and makes the component (A), which is a main component of the capturing composition and the capturing sheet of the present invention, softer. This makes it possible to absorb the impact when the semiconductor element separated from the transfer source substrate comes into contact with the capturing composition and the capturing sheet of the present invention and prevent the semiconductor element from being damaged and from being misaligned due to rebound.

In view of this, the (B) water-soluble plasticizer is preferably in liquid form at the time of capturing or bonding the components in order to further soften the component (A). For example, the (B) water-soluble plasticizer is preferably in liquid form at normal temperature (25°C).

The (B) water-soluble plasticizer of the present invention is other than the component (A). The (B) water-soluble plasticizer of the present invention includes water.

The boiling point of the (B) water-soluble plasticizer is not particularly limited and 120°C or higher, preferably 150°C or higher, and even more preferably 180°C or higher, for example. The (B) water-soluble plasticizer having a boiling point of 120°C or higher is less likely to evaporate at the time of capturing; therefore, properties of the water-soluble adhesive composition for component capture and the water-soluble adhesive sheet for component capture of the present invention are less likely to change.

Further, since the water-soluble adhesive composition for component capture and the water-soluble adhesive sheet for component capture of the present invention are subjected to the bonding process involving applying heat and/or pressure, the (B) water-soluble plasticizer is preferably a plasticizer that is a liquid whose vapor pressure at the temperature in the bonding process is below atmospheric pressure. In the case of a plasticizer that is a liquid whose vapor pressure at a temperature at this time is below atmospheric pressure, the evaporation does not occur. It is therefore possible to reduce the formation of vapor bubbles (so-called "voids") in the capturing composition and the capturing sheet.

The upper limit of the boiling point of the (B) water-soluble plasticizer is not particularly limited and is 500°C or lower, for example.

The (B) water-soluble plasticizer is removed by washing with water after the bonding process. Thus, the (B) water-soluble plasticizer can be used without limitation as long as it dissolves in water. For efficient washing with water, the solubility of the (B) water-soluble plasticizer in water is preferably 0.10 g/g-H₂O or more, more preferably 0.30 g/g-H₂O or more, and even more preferably 0.50 g/g-H₂O or more at normal temperature (25°C).

It is not only preferred that the (B) water-soluble plasticizer has a property of not inhibiting the meltability of the component (A) in the bonding process and having superior water solubility, but also preferred that an aqueous solution of the (B) water-soluble plasticizer has low viscosity.

For example, the (B) water-soluble plasticizer is preferably in liquid form at normal temperature (25°C). The upper limit of the viscosity of the (B) water-soluble plasticizer is preferably 50000 mPa·s or less, more preferably 40000 mPa·s or less, even more preferably 1000 mPa·s or less, and far more preferably 600 mPa·s or less at normal temperature (25°C). On the other hand, the lower limit is not particularly limited, but is preferably 0.8 mPa·s or more and more preferably 1.0 mPa·s or more.

The viscosity of an aqueous solution depends on the molecular weight of the solute; therefore, for example, the molecular weight of the compound used as the (B) water-soluble plasticizer is preferably 5000 or less, more preferably 3000 or less, even more preferably 1000 or less, far more preferably 800 or less, and particularly preferably 600 or less. In the description of the present invention, the molecular weight of the water-soluble plasticizer having a molecular weight distribution means a weight-average molecular weight.

The (B) water-soluble plasticizer of a kind is selected which does not impair the effects of the present invention as a result of a decrease in the solubility of a solvent, the meltability, and the surface tension due to a reaction or interaction with the component (A).

For example, when the component (A) and the component (B) react to form a three dimensional crosslinked structure, the solubility of the solvent, the meltability, and the surface tension are impaired.

The water-soluble plasticizer that is the component (B) of the present invention is preferably a monohydric or polyhydric alcohol and alkanolamine. These have a plurality of hydrophilic functional groups and are therefore superior in terms of water solubility.

More specific examples of the (B) water-soluble plasticizer include, for example, glycerin, diglycerin, ethylene glycol, diethylene glycol, propane-1,2-diol, 1,3-propanediol, diethylene glycol monomethyl ether, ethanolamine, trimethanolamine, etc.
Examples of polymeric water-soluble plasticizer include polyethylene glycol, monoalkoxy-terminated polyethylene glycol, dialkoxy-terminated polyethylene glycol, polyglycerin, propylene glycol, polypropylene glycol, etc.

Here, the (B) water-soluble plasticizer is preferably glycerin, diglycerin, polyethylene glycol, polypropylene glycol, and triethanolamine. Glycerin, diglycerin, polyethylene glycol, polypropylene glycol, and triethanolamine are superior in miscibility with water and has a high boiling point. These substances are preferable because they provide superior meltability and surface tension of the capturing sheet in the bonding process and are superior in washing with water in the cleaning process. Glycerin, diglycerin, polyethylene glycol, and polypropylene glycol, which are readily available and handled, are more preferable; glycerin and polyethylene glycol are even more preferable.

The ratio ((B)/(A)) of the content of the (B) water-soluble plasticizer to the content of the (A) water-soluble adhesive is greater than 0.5 and 3.0 or less. As shown in Examples described later, failing to satisfy this value may result in insufficient impact absorption and insufficient stickiness and adhesiveness, and impaired handling in attachment and peeling.

### [Other Components]

The capturing sheet of the present invention may contain water in an amount of 10% by mass or less with respect to the entirety of the capturing sheet, in a range that does not impair the effect of the present invention.

The capturing composition and the capturing sheet of the present invention may contain other components in a range that does not impair the effect of the present invention.

Examples of the other components include a lubricant, an antioxidant, an antistatic agent, a surfactant, a heat stabilizer, a rust inhibitor, and a surface conditioner (leveling agent).

The capturing composition and the capturing sheet of the present invention preferably do not contain a thermosetting resin, because the thermosetting resin is cured in the bonding process and cannot be removed by washing with water or the like in some cases.

### [Method For Producing Water-Soluble Adhesive Composition For Component Capture]

The water-soluble adhesive composition for component capture of the present invention can be produced by using a known production method.

For example, the composition can be produced by kneading the raw materials shown in Tables 1 and 2 described later with a mixer or the like.

### [Method For Producing Water-Soluble Adhesive Sheet For Component Capture]

The water-soluble adhesive sheet for component capture of the present invention can be produced by using a known production method relating to production of sheets containing an adhesive.

For example, the sheet can be produced by forming a layer using the water-soluble adhesive composition for component capture of the present invention on a prepared release sheet.

The base of the release sheet is not particularly limited as long as it is possible to release the water-soluble adhesive composition for component capture of the present invention. Examples of the base of the release sheet include, for example, polyester, polyolefin, and polyamide.

Examples of the polyester include polyethylene terephthalate, polytetramethylene terephthalate, polyethylene naphthalate, polytetramethylene terephthalate, etc.

Examples of the polyolefin include, for example, linear low-density polyethylene, low-density polyethylene, medium-density polyethylene, polypropylene, etc.

Examples of the polyamide include, for example, polycaprolactam, polyhexamethylene adipamide, polytetramethylene adipamide, polyhexamethylene isophthalamide, polyhexamethylene sebacamide, polyhexamethylene dodecamide, polyhexamethylene terephthalamide, polynonamethylene terephthalamide, polydecamethylene terephthalamide, polyundecanelactam, polydodecanelactam, polymetaxylylene adipamide, etc.

The release sheet may be subjected to a known release treatment on at least one surface.

The layer using the water-soluble adhesive composition for component capture of the present invention may be formed on one or both surfaces of the release sheet.

The method for forming a layer using the capturing composition of the present invention is not particularly limited, and a known method can be used.

For example, the capturing sheet can be produced by dissolving or dispersing a composition containing all or some of the components constituting the capturing sheet in a solvent and applying a resultant substance to the release sheet.

Examples of the solvent include water, an organic solvent, and a mixture of water and an organic solvent. Examples of the organic solvent include methanol, ethanol, 1-propanol, 2-propanol, 1-butanol, 2-butanol, 2-methyl-1-propanol, 2-methyl-2-propanol, 1-pentanol, 2-pentanol, 3-pentanol, 2-methyl-1-butanol, 2-methyl-2-butanol, 3-methyl-1-butanol, 3-methyl-2-butanol, 2,2-dimethyl-1-propanol, etc.

The application method is not particularly limited as long as the layer using the capturing composition of the present invention can be formed into a uniform thickness. For example, spin coating, blade coating, slit coating, and slot-die coating may be employed as a method for forming a layer having a uniform thickness.

In a case of using a composition containing some of the components constituting the capturing sheet, after the layer formation, a liquid component (for example, the component (B)) may be impregnated or replace the components before or after the drying of the capturing sheet, for example.

The drying temperature at this moment is 60°C to 140°C and preferably 80°C to 120°C.

### [How To Use Water-Soluble Adhesive Composition For Component Capture (Water-Soluble Adhesive Sheet For Component Capture)]

The water-soluble adhesive composition for component capture and the water-soluble adhesive sheet for component capture of the present invention can be used, for example, for the production of electronic components having the following steps.

How to use the water-soluble adhesive sheet for component capture of the present invention will be mainly described below. The following description relating to how to use the water-soluble adhesive composition for component capture (water-soluble adhesive sheet for component capture) can be replaced with the description of the method for producing the electronic components according to the present invention:
(1) Process of placing the capturing sheet (capturing composition) of the present invention on the electrode surface side of the wiring substrate and laminating (applying) the capturing sheet;
(2) Process of capturing semiconductor elements on the capturing sheet (capturing composition) of the present invention;
(3) Bonding process of electrically bonding the semiconductor elements to the wiring substrate;
(4) Cleaning process of removing residues; and
(5) Drying process for the wiring substrate.

### <(1) Laminating Process>

In the process of placing the capturing sheet of the present invention on the electrode surface side of the wiring substrate and laminating the capturing sheet, the capturing sheet of the present invention formed on a release sheet is laminated to the wiring substrate. If the capturing sheet of the present invention has a release sheet, the release sheet is peeled off.

The electrode surface of the wiring substrate may be cleaned before laminating the capturing sheet of the present invention. An organic solvent, an acidic aqueous solution, a basic aqueous solution, or the like can be used for cleaning.

The wiring substrate is not particularly limited as long as it is a substrate provided with wiring, and examples thereof include, for example, a TFT back plane which is a glass substrate, FR-4 which is a glass epoxy substrate, a ceramic substrate, and a silicon wafer.

Instead of the laminating process using the capturing sheet of the present invention, the capturing composition of the present invention may be applied directly to the electrode surface side of the wiring substrate and dried.

### <(2) Capturing Process>

In the process of capturing semiconductor elements on the capturing sheet of the present invention, components (elements) are placed at desired positions on the substrate. This capturing process may also be a transfer process in the semiconductor production.

The transfer process is a process of determining the positions of the semiconductor elements on the wiring substrate and moving the semiconductor elements from a transfer source, i.e., the substrate on which the semiconductor elements are formed or the substrate which temporarily holds the semiconductor elements, onto a transfer target, i.e., the capturing sheet of the present invention. A non-contact transfer process and a contact transfer process are known as a transfer process, but the transfer process is not particularly limited thereto.

### - Non-Contact Transfer Process

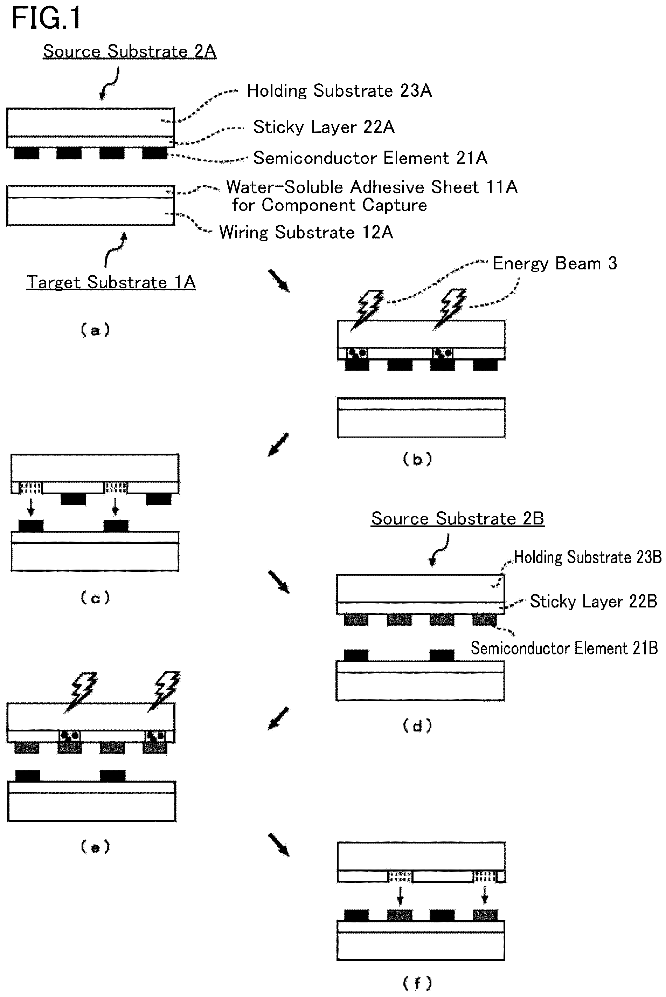

As an embodiment of the transfer process, an example of a non-contact transfer process will be described with reference to FIG. 1. The transfer process using the capturing sheet of the present invention is not limited to the exemplified embodiment. The drawings are partially enlarged or reduced in size for easy understanding of the description.

(i) The transfer target substrate 1A shown in FIG. 1(a) produced in the above (1) Laminating Process and the transfer source substrate 2A are arranged with a gap therebetween such that the surface of the water-soluble adhesive sheet 11A for component capture of the present invention opposite to the surface laminated to the wiring substrate 12A being opposed to the surface of the transfer source substrate 2A where the semiconductor elements 21A are formed.
   Here, the transfer source substrate 2A shown in FIG. 1(a) has the semiconductor elements 21A held by a sticky layer 22A formed on one surface of a holding substrate 23A for temporarily holding the elements.
(ii) As shown in FIG. 1(b), energy beams (e.g., lasers) 3 are emitted to the position(s) of desired one semiconductor element or two or more semiconductor elements from the surface of the transfer source substrate 2A opposite to the surface where the semiconductor elements 21A are formed. As shown in FIG. 1(c), the semiconductor elements 21A are separated from the transfer source substrate 2A by irradiation with the energy beams (e.g., lasers) 3, and the separated semiconductor elements 21A adhere to, and are transferred to, the capturing sheet 11A that is a transfer target.
(iii) Thereafter, as shown in FIG. 1(d), a transfer source substrate 2B including a holding substrate 23B temporarily holding semiconductor elements 21B different from the semiconductor elements 21A is moved to a desired position with respect to the transfer target substrate 1A. After the movement, the step of the above item (ii) is repeated as shown in FIGS. 1(e) and 1(f).
(iv) The steps of the above items (ii) and (iii), and, if necessary, the above item (i) are repeated, so that the semiconductor elements are transferred and placed at all desired positions of the transfer target substrate 1A (not shown).

The holding substrates 23A and 23B of the transfer source substrates 2A and 2B may be any of, for example, a sapphire substrate, quartz glass, glass, and plastic. The separation between the holding substrate 23A and the semiconductor elements 21A and the separation between the holding substrate 23B and the semiconductor elements 21B are caused by, for example, decomposition (and foaming), aggregation, or softening and melting of components constituting the sticky layers 22A and 22B by irradiation with the energy beams (e.g., lasers) 3.

Thus, in order that the energy of the energy beams (e.g., lasers) 3 is absorbed efficiently in the sticky layers 22A and 22B, the holding substrates 23A and 23B are preferably those which transmit the energy beam 3 or those which absorb less energy beam 3.

The components constituting the sticky layers 22A and 22B of the transfer source substrates 2A and 2B include adhesive components. Examples of the adhesive components include, for example, silicone, an acrylic polymer, a polyvinyl alcohol-based polymer, and a vinylpyrrolidone-based polymer. The components constituting the sticky layers 22A and 22B may include components that foam or crosslinking components that promote aggregation by the energy beam (laser) 3.

Examples of the energy beam 3 include a laser, for example. Examples of the laser include, for example, an excimer laser and a harmonic YAG laser.

### - Contact Transfer Process

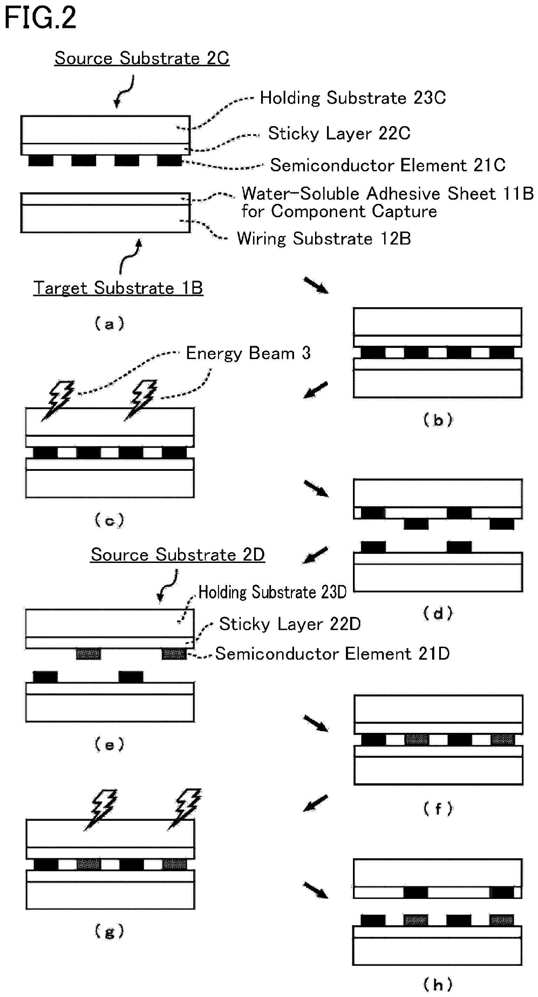

Next, as another embodiment of the transfer process, a contact transfer process will be described with reference to FIG. 2.

This embodiment is the same as the non-contact transfer process except that the transfer is performed by bringing the semiconductor elements on the holding substrate temporarily holding the elements into contact with the capturing sheet of the present invention on the substrate. Thus, the following items (i) to (iv) will be described, and the description of the other contents common to the non-contact transfer process will be omitted.

(i) As shown in FIGS. 2(a) and 2(b), semiconductor elements 21C on the transfer source substrate 2C are brought into contact with the water-soluble adhesive sheet 11B for component capture on the transfer target substrate 1B.
(ii) As shown in FIG. 2(c), energy beams (e.g., lasers) 3 are emitted to the position(s) of desired one semiconductor element or two or more semiconductor elements from the surface of the transfer source substrate 2C opposite to the surface where the semiconductor elements 21C are formed. As shown in FIG. 2(d), the semiconductor elements 21C are separated from the transfer source substrate 2C that is a transfer source by irradiation with the energy beams (e.g., lasers) 3, and the separated semiconductor elements 21C adhere to, and are transferred to, the capturing sheet 11B that is a transfer target.
(iii) After the transfer of the separated semiconductor elements 21C, a transfer source substrate 2D including a holding substrate 23D holding semiconductor elements 21D different from the semiconductor elements 21C is moved to a desired position as shown in FIG. 2(e), and the semiconductor elements 21D on the transfer source substrate 2D are brought into contact with the capturing sheet 11B. After the contact, the step of the above item (ii) is repeated as shown in FIGS. 2(f) and 2(h).
(iv) The steps of the above items (ii), (iii), and, if necessary, the above item (i) are repeated, so that the semiconductor elements are transferred and placed at all desired positions of the transfer target substrate 1B (not shown).

### - Variations of Embodiments in Transfer Process

Embodiments in the transfer process are not limited to those described above. Variations and improvements can be included within the scope in which the object of the present invention can be achieved.

All the semiconductor elements formed on the holding substrate in the non-contact transfer process or the contact transfer process may be irradiated with the energy beam (laser) to transfer the semiconductor elements at once.

In the item (iii) of the above non-contact transfer process or the contact transfer process, the transfer target substrates 1A and 1B may be moved instead of the holding substrate (23B and 23D) or together with the holding substrate (23B or 23D).

Further, an element-forming substrate can be used instead of the transfer source substrate (2A, 2B, 2C, and 2D) or together with the transfer source substrate (2A, 2B, 2C, and 2D) in the non-contact transfer process or the contact transfer process.

For example, the element-forming substrate may be a sapphire substrate on which light-emitting diodes have been formed by forming a laminate including various layers, such as a conductive layer, on the sapphire substrate, and making a semiconductor crystal grow on the laminate or by any other way. When the crystal is irradiated with a laser through the sapphire substrate, the surface of the layer at the interface with the sapphire substrate is decomposed, thereby making it possible to separate the light-emitting diodes.

### <(3) Bonding Process>

**In** the bonding process of electrically bonding the elements to the wiring substrate, the capturing composition and the capturing sheet of the present invention are softened or melted by applying heat and/or pressure. The elements and the wiring substrate are electrically bonded due to softening or melting of the capturing composition and the capturing sheet of the present invention between the elements and the wiring substrate.

The temperature of the bonding process is selected depending on the properties of the resin and the solder, and is, for example, 150°C, 160°C. Heating may also be performed in multiple stages.

The maximum temperature of the bonding process is selected depending, for example, on the heat resistance of the semiconductor element, and is preferably 260°C or lower, more preferably 240°C or lower, and even more preferably 230°C or lower.

### <(4) Cleaning Process>

The capturing composition and the capturing sheet of the present invention remain after the bonding process. Residues are therefore removed by cleaning.

For cleaning, only water from which ions are removed (e.g., ultrapure water, ion-exchanged water, and distilled water) may be used, or a mixture of a water-soluble organic solvent and water may be used. However, from the viewpoint of its lower impact on the environment and easier availability, only water from which ions are removed is preferable. Hereinafter, water from which ions are removed and a mixture of a water-soluble organic solvent and water are also referred to as "water and the like." An additive for hydrolyzing the water-soluble adhesive may be added to the water and the like. For example, the additive may be a hydrolase such as amylase, glucoamylase, pullulanase, cellulase, and protease. In using these hydrolases, it is preferable to perform cleaning in the optimum pH and temperature range for exhibiting high enzymatic activity, and it is possible, depending on the enzyme, to further increase the enzymatic activity by the addition of an additive such as Ca²⁺.

The water-soluble organic solvent may be alcohol and ketone, for example, and is preferably alcohol. In the case of using a water-soluble organic solvent, the solvent may be used alone or in combination of two or more kinds thereof. Examples of the alcohol include methanol, ethanol, n-propanol, n-butanol, etc. Examples of the ketone include acetone, methyl ethyl ketone, etc. The water-soluble organic solvent may be a mixture of water from which ions are removed and a water-soluble organic solvent. The mixing ratio is not particularly limited, but a lower percentage of the water-soluble organic solvent is preferable from the viewpoint of reducing an impact on the environment.

Further, a surfactant may be added as an additive to the water and the like in order to improve the penetration of the water and the like into narrow gaps. Other additives that enhance cleaning may also be added.

The temperature of the water and the like to be used in the cleaning process is selected depending on the solubility of the component (A) and the component (B). For example, the temperature of the water and the like to be used in the washing with water is preferably 10°C or higher, more preferably 20°C or higher, and even more preferably 30°C or higher.

The temperature of 10°C or higher is preferred because of the tendency of no residue or fewer residues after cleaning.

The temperature of the water and the like to be used in the washing with water is preferably 80°C or lower, more preferably 70°C or lower, and even more preferably 60°C or lower.

The temperature of 80°C or lower is preferred because of less energy consumption and a lower impact on the environment.

In using a hydrolase, since each enzyme has an optimum temperature range exhibiting high activity, the cleaning is preferably carried out at such a temperature.

### <(5) Drying Process>

The drying process of the wiring substrate may be carried out by dewatering by centrifugal force (spin dryer) or drying after cleaning with a highly evaporative, water-miscible organic solvent (e.g., isopropanol).

The drying temperature can be appropriately designed in accordance with the boiling point of the solvent, for example.

### Examples

The present invention will be described in detail below with reference to Examples, but the technical scope of the present invention is not limited to these Examples.

The measurement methods and evaluation methods used in the present invention are as follows.

### Measurement Method

### (1) Composition Calculation for Capturing Sheet

[1] For the capturing sheets shown in Tables 3 and 4, the amount of moisture contained in each capturing sheet was measured by the Karl Fischer method. The composition was calculated on the assumption that the (A) water-soluble adhesive and the (B) water-soluble plasticizer were not removed from the system by evaporation or the like in the drying process of the production of the capturing sheet, and that all the solvents other than water were removed from the system.

### (2) Measurement of Viscosity

The viscosity of the sample at 25°C was measured by a rotational viscometer (TVE-25H type viscometer, manufactured by Toki Sangyo Co., Ltd.). The number of revolutions was 1 rpm (polyglycerin), 50 rpm (glycerin, PEG600, PPG3000), 100 rpm (diethylene glycol, ethylene glycol, propylene glycol, PEG400, diethylene glycol monomethyl ether).

### Evaluation Method

### (1) Evaluation Method for Sticking Force

A glass plate (AS ONE CORPORATION, product name: slide glass, thickness: 1.0 mm to 1.2 mm, weight: 5 g) and a water-soluble adhesive sheet for component capture (thickness: 5 µm) were pressed against each other at normal temperature (25°C) using a roller, and then a polyethylene terephthalate film was peeled off. The bottom of a cylindrical glass pipe having a diameter of 10 mm was pressed against the center of the glass plate to which the capturing sheet was attached, and they were lifted in this state by hand. The time until the bottom of the glass pipe and the capturing sheet came off from each other and the glass plate dropped was measured.
○: The sample did not drop for 41 seconds or more.
△: The sample dropped within 21 to 40 seconds.
×: The sample dropped within 20 seconds.

### (2) Evaluation Method for Tackiness

A ball rolling device having a slope with an inclination angle of 10° and a horizontal surface continuous with the lower part of the slope was used. A capturing sheet (thickness: 5 µm) was attached to the horizontal surface, and a test ball (made of alumina, weighing 0.1 g, and having a diameter of 4 mm) was rolled from above the upper part of the slope (9 mm height) to measure the distance to the position where the test ball stopped.
○: The test ball stopped within 9 mm.
△: The test ball stopped within 10 mm to 20 mm.
×: The test ball did not stop within 20 mm.

The sticking force and the tackiness are both for evaluating the capturing property of the water-soluble adhesive sheet for component capture.

### (3) Evaluation Method for Ease of Handling in Attachment and Peeling

A glass plate (AS ONE CORPORATION, product name: slide glass, thickness: 1.0 mm to 1.2 mm, weight: 5 g) and a water-soluble adhesive sheet for component capture (thickness: 5 µm) were pressed against each other at normal temperature (25°C) using a roller, and then a release film (polyethylene terephthalate film) was peeled off. Whether the capturing sheet remained on the release film and stringing or uneven separation (incomplete separation) occurred was visually checked at this moment.
○: Neither stringing nor uneven separation (incomplete separation) occurred.
△: Stringing and uneven separation (incomplete separation) slightly occurred.
×: Stringing and uneven separation (incomplete separation) occurred at multiple portions, or attachment itself failed.

Tables 1 and 2 show the components and ratios of the raw materials (water-soluble adhesive composition for component capture) used for the production of the sheets of Examples and Comparative Examples. Tables 3 and 4 show the percentage based on the mass of each component of the sheet (water-soluble adhesive sheet for component capture) produced using the raw material (water-soluble adhesive composition for component capture) and the evaluation results.

### [Example 1]

### (Production of Capturing Sheet)

A polyvinylpyrrolidone solution was obtained by dissolving 50 parts by mass of polyvinylpyrrolidone (K-30, DKS Co. Ltd.) and 35 parts by mass of polyethylene glycol (PEG #400, manufactured by NOF Corporation) in 350 parts by mass of ion-exchanged water.

The polyvinylpyrrolidone solution was applied to a polyethylene terephthalate film (6502, manufactured by LINTEC Corporation) subjected to a release treatment using an applicator.

The film was dried at 100°C to obtain a capturing sheet having a film thickness of 5 µm. The temperature during drying in the following Examples and Comparative Examples was 100°C when the solvent is ion-exchanged water or ethanol, and 120°C when the solvent is 1-butanol.

### [Example 2]

### (Production of Capturing Sheet)

A capturing sheet was obtained in the same manner except that a polyvinylpyrrolidone solution prepared by dissolving 50 parts by mass of polyvinylpyrrolidone (K-50, DKS Co. Ltd.) and 45 parts by mass of diethylene glycol in 350 parts by mass of ethanol was used instead of the polyvinylpyrrolidone solution of Example 1.

### [Example 3]

### (Production of Capturing Sheet)

A capturing sheet was obtained in the same manner except that a polyvinylpyrrolidone solution prepared by dissolving 50 parts by mass of polyvinylpyrrolidone (K-85N, NIPPON SHOKUBAI CO., LTD.) and 60 parts by mass of ethylene glycol in 350 parts by mass of 1-butanol was used instead of the polyvinylpyrrolidone solution of Example 1.

### [Example 4]

### (Production of Capturing Sheet)

A capturing sheet was obtained in the same manner except that a polyvinylpyrrolidone solution prepared by dissolving 50 parts by mass of polyvinylpyrrolidone (K-85N, NIPPON SHOKUBAI CO., LTD.) and 70 parts by mass of polyethylene glycol (PEG #400, manufactured by NOF Corporation) in 350 parts by mass of ethanol was used instead of the polyvinylpyrrolidone solution of Example 1.

### [Example 5]

### (Production of Capturing Sheet)

A capturing sheet was obtained in the same manner except that a polyvinylpyrrolidone solution prepared by dissolving 50 parts by mass of polyvinylpyrrolidone (K-85N, NIPPON SHOKUBAI CO., LTD.) and 80 parts by mass of polyethylene glycol (PEG #600, FUJIFILM Wako Pure Chemical Corporation) in 350 parts by mass of 1-butanol was used instead of the polyvinylpyrrolidone solution of Example 1.

### [Example 6]

### (Production of Capturing Sheet)

A capturing sheet was obtained in the same manner except that a polyvinylpyrrolidone solution prepared by dissolving 50 parts by mass of polyvinylpyrrolidone (K-85N, NIPPON SHOKUBAI CO., LTD.) and 90 parts by mass of polypropylene glycol (PPG #3000, FUJIFILM Wako Pure Chemical Corporation) in 350 parts by mass of 1-butanol was used instead of the polyvinylpyrrolidone solution of Example 1.

### [Example 7]

### (Production of Capturing Sheet)

A capturing sheet was obtained in the same manner except that a polyvinylpyrrolidone solution prepared by dissolving 50 parts by mass of polyvinylpyrrolidone (K-85N, NIPPON SHOKUBAI CO., LTD.) and 110 parts by mass of propylene glycol in 350 parts by mass of 1-butanol was used instead of the polyvinylpyrrolidone solution of Example 1.

### [Example 8]

### (Production of Capturing Sheet)

A capturing sheet was obtained in the same manner except that a polyvinylpyrrolidone solution prepared by dissolving 50 parts by mass of polyvinylpyrrolidone (K-90N, NIPPON SHOKUBAI CO., LTD.) and 130 parts by mass of polyglycerin (PGL 20PW, manufactured by Daicel Corporation) in 350 parts by mass of ethanol was used instead of the polyvinylpyrrolidone solution of Example 1.

### [Example 9]

### (Production of Capturing Sheet)

A capturing sheet was obtained in the same manner except that a polyvinylpyrrolidone solution prepared by dissolving 50 parts by mass of polyvinylpyrrolidone (K-90N, NIPPON SHOKUBAI CO., LTD.) and 140 parts by mass of polyglycerin (PLG20PW, manufactured by Daicel Corporation) in 350 parts by mass of ethanol was used instead of the polyvinylpyrrolidone solution of Example 1.

### [Example 10]

### (Production of Capturing Sheet)

A capturing sheet was obtained in the same manner except that a polyvinyl alcohol solution prepared by dissolving 50 parts by mass of polyvinyl alcohol (GOHSENOL (registered trademark) GR-14, manufactured by The Nippon Synthetic Chemical Industry Co., Ltd.) and 40 parts by mass of diethylene glycol monomethyl ether in 350 parts by mass of ion-exchanged water was used instead of the polyvinylpyrrolidone solution of Example 1.

### [Example 11]

### (Production of Capturing Sheet)

A capturing sheet was obtained in the same manner except that a polyacrylic acid solution prepared by dissolving 50 parts by mass of polyacrylic acid (AS-58, manufactured by NIPPON SHOKUBAI CO., LTD.) and 100 parts by mass of glycerin in 350 parts by mass of ion-exchanged water was used instead of the polyvinylpyrrolidone solution of Example 1.

### [Example 12]

### (Production of Capturing Sheet)

A capturing sheet was obtained in the same manner except that a pullulan solution prepared by dissolving 50 parts by mass of pullulan (manufactured by Hayashibara Co., Ltd.), 80 parts by mass of polyethylene glycol (PEG #600, FUJIFILM Wako Pure Chemical Corporation), and 20 parts by mass of glycerin in 350 parts by mass of ethanol was used instead of the polyvinylpyrrolidone solution of Example 1.

### [Example 13]

### (Production of Capturing Sheet)

A capturing sheet was obtained in the same manner except that a mixed solution prepared by dissolving 30 parts by mass of polyvinylpyrrolidone (K-85N, NIPPON SHOKUBAI CO., LTD.), 20 parts by mass of polyvinyl alcohol (GOHSENOL (registered trademark) GR-14, manufactured by The Nippon Synthetic Chemical Industry Co., Ltd.), and 90 parts by mass of glycerin in 100 parts by mass of ion-exchanged water and 250 parts by mass of 1-butanol was used instead of the polyvinylpyrrolidone solution of Example 1.

### [Comparative Example 1]

A comparative sheet was obtained in the same manner except that a polyvinylpyrrolidone solution prepared by dissolving 50 parts by mass of polyvinylpyrrolidone (K-30, DKS Co. Ltd.) and 25 parts by mass of polyethylene glycol (PEG #400, manufactured by NOF Corporation) in 350 parts by mass of ethanol was used instead of the polyvinylpyrrolidone solution of Example 1.

### [Comparative Example 2]

A comparative sheet was obtained in the same manner except that a polyvinylpyrrolidone solution prepared by dissolving 50 parts by mass of polyvinylpyrrolidone (K-90N, NIPPON SHOKUBAI CO., LTD.) and 160 parts by mass of polyglycerin in 350 parts by mass of ethanol was used instead of the polyvinylpyrrolidone solution of Example 1.

The weight-average molecular weight Mw of the water-soluble adhesive that is the component (A) used in Examples and Comparative Examples is as follows.
- Polyvinylpyrrolidone
   K-30: 45000, K-50: 250000
   K-85N: 340000, K-90N: 360000
- Polyvinyl Alcohol (GR-14): 29000
- Polyacrylic Acid (AS-58): 800000
- Pullulan: 200000

**[Table 1]**

| | | | Example 1 | Example 2 | Example 3 | Example 4 | Example 5 | Example 6 | Example 7 | Example 8 |
|---|---|---|---|---|---|---|---|---|---|---|
| (A) Water-Soluble Adhesive (Unit: parts by mass) | Polyvinylpyrrolidone | | 50.0 | 50.0 | 50.0 | 50.0 | 50.0 | 50.0 | 50.0 | 50.0 |
| | Polyvinyl Alcohol | | | | | | | | | |
| | Polyacrylic Acid | | | | | | | | | |
| | Pullulan | | | | | | | | | |
| (B) Water-Soluble Plasticizer (Unit: parts by mass) | Water-Soluble Plasticizer 1 (Mw < 500) | Viscosity (m Pa·s) | | | | | | | | |
| | Ethylene Glycol | 25.2 | | | 60.0 | | | | | |
| | Diethylene Glycol | 26.1 | | 45.0 | | | | | | |
| | Propylene Glycol | 40.8 | | | | | | | 110.0 | |
| | PEG # 400 | 90.3 | 35.0 | | | 70.0 | | | | |
| | Glycerin | 896 | | | | | | | | |
| | Water-Soluble Plasticizer 2 (Mw < 500) | Viscosity (m Pa·s) | | | | | | | | |
| | Diethylene Glycol Monom ethyl Ether | 0.8 | | | | | | | | |
| | Water-Soluble Plasticizer 3 (Mw < 500) | Viscosity (m Pa·s) | | | | | | | | |
| | PEG # 600 | 128 | | | | | 80.0 | | | |
| | PPG # 3000 | 537 | | | | | | 90.0 | | |
| | Polyglycerin | 37890 | | | | | | | | 130.0 |
| Solvent (Unit: parts by mass) | Water | | 350.0 | | | | | | | |
| | Ethanol | | | 350.0 | | 350.0 | | | | 350.0 |
| | 1-Butanol | | | | 350.0 | | 350.0 | 350.0 | 350.0 | |
| Total | | | 435.0 | 445.0 | 460.0 | 470.0 | 480.0 | 490.0 | 510.0 | 530.0 |

| | | | | | | | | | | |
|---|---|---|---|---|---|---|---|---|---|---|
| PEG: Polyethylene Glycol PPG: Polypropylene Glycol | | | | | | | | | | |

**[Table 2]**

| | | | Example 9 | Example 10 | Example 11 | Example 12 | Example 13 | Comparative Example 1 | Comparative Example 2 |
|---|---|---|---|---|---|---|---|---|---|
| (A) Water-Soluble Adhesive (Unit: parts by mass) | Polyvinylpyrrolidone | | 50.0 | | | | 30.0 | 50.0 | 50.0 |
| | Polyvinyl Alcohol | | | 50.0 | | | 20.0 | | |
| | Polyacrylic Acid | | | | 50.0 | | | | |
| | Pullulan | | | | | 50.0 | | | |
| (B) Water-Soluble Plasticizer (Unit: parts by mass) | Water-Soluble Plasticizer 1 (Mw < 500) | Viscosity (mPa·s) | | | | | | | |
| | Ethylene Glycol | 25.2 | | | | | | | |
| | Diethylene Glycol | 26.1 | | | | | | | |
| | Propylene Glycol | 40.8 | | | | | | | |
| | PEG # 400 | 90.3 | | | | | | 25.0 | |
| | Glycerin | 896 | | | 100.0 | 20.0 | 90.0 | | |
| | Water-Soluble Plasticizer 2 (Mw < 500) | Viscosity (mPa·s) | | | | | | | |
| | Diethylene Glycol Monomethyl Ether | 0.8 | | 40.0 | | | | | |
| | Water-Soluble Plasticizer 3 (Mw < 500) | Viscosity (mPa·s) | | | | | | | |
| | PEG # 600 | 128 | | | | 80.0 | | | |
| | PPG # 3000 | 537 | | | | | | | |
| | Polyglycerin | 37890 | 140.0 | | | | | | 160.0 |
| Solvent (Unit: parts by mass) | Water | | | 350.0 | 350.0 | 350.0 | 100.0 | | |
| | Ethanol | | 350.0 | | | | | 350.0 | 350.0 |
| | 1-Butanol | | | | | | 250.0 | | |
| Total | | | 540.0 | 440.0 | 500.0 | 500.0 | 490.0 | 425.0 | 560.0 |

**[Table 3]**

| | | | Example 1 | Example 2 | Example 3 | Example 4 | Example 5 | Example 6 | Example 7 | Example 8 |
|---|---|---|---|---|---|---|---|---|---|---|
| (A) W ater-Soluble Adhesive (Unit: % by mass) | Polyvinylpyrrolidone | | 58.14 | 52.08 | 45.05 | 41.32 | 38.17 | 35.46 | 31.06 | 27.62 |
| | Polyvinyl Alcohol | | | | | | | | | |
| | Polyacrylic Acid | | | | | | | | | |
| | Pullulan | | | | | | | | | |
| (B) W ater-Soluble Plasticizer (Unit: % by mass) | Water-Soluble Plasticizer 1 (Mw < 500) | Viscosity (m Pa·s) | | | | | | | | |
| | Ethylene Glycol | 25.2 | | | 54.05 | | | | | |
| | Diethylene Glycol | 26.1 | | 46.88 | | | | | | |
| | Propylene Glycol | 40.8 | | | | | | | 68.32 | |
| | PEG # 400 | 90.3 | 40.70 | | | 57.85 | | | | |
| | Glycerin | 896 | | | | | | | | |
| | Water-Soluble Plasticizer 2 (Mw < 500) | Viscosity (m Pa·s) | | | | | | | | |
| | Diethylene Glycol Monom ethyl Ether | 0.8 | | | | | | | | |
| | Water-Soluble Plasticizer 3 (Mw < 500) | Viscosity (m Pa·s) | | | | | | | | |
| | PEG # 600 | 128 | | | | | 61.07 | | | |
| | PPG # 3000 | 537 | | | | | | 63.83 | | |
| | Polyglycerin | 37890 | | | | | | | | 71.82 |
| **Residual Solvent** (Unit: % by mass) | Water | | 1.16 | | | | | | | |
| | Ethanol | | | 1.04 | | 0.83 | | | | 0.55 |
| | 1-Butanol | | | | 0.90 | | 0.76 | 0.71 | 0.62 | |
| (B)/(A) | | | 0.7 | 0.9 | 1.2 | 1.4 | 1.6 | 1.8 | 2.2 | 2.6 |
| Capturing Property | Sticking Force | | ○ | ○ | ○ | ○ | ○ | ○ | ○ | Δ |
| | Tack | | Δ | Δ | ○ | ○ | ○ | ○ | ○ | ○ |
| Ease of Handling | | | ○ | ○ | ○ | ○ | ○ | ○ | ○ | Δ |

**[Table 4]**

| | | | Example 9 | Example 10 | Example 11 | Example 12 | Example 13 | Comparative Example 1 | Comparative Example 2 |
|---|---|---|---|---|---|---|---|---|---|
| (A) Water-Soluble Adhesive (Unit: % by mass) | Polyvinylpyrrolidone | | 26.18 | | | | 21.26 | 65.79 | 23.70 |
| | Polyvinyl Alcohol | | | 54.95 | | | 14.17 | | |
| | Polyacrylic Acid | | | | 33.11 | | | | |
| | Pullulan | | | | | 33.11 | | | |
| (B) Water-Soluble Plasticizer (Unit: % by mass) | Water-Soluble Plasticizer 1 (Mw< 500) | Viscosity (mPa·s) | | | | | | | |
| | Ethylene Glycol | 25.2 | | | | | | | |
| | Diethylene Glycol | 26.1 | | | | | | | |
| | Propylene Glycol | 40.8 | | | | | | | |
| | PEG # 400 | 90.3 | | | | | | 32.90 | |
| | Glycerin | 896 | | | 66.23 | 13.25 | 63.79 | | |
| | Water-Soluble Plasticizer 2 (Mw< 500) | Viscosity (mPa·s) | | | | | | | |
| | Diethylene Glycol Monomethyl Ether | 0.8 | | 43.96 | | | | | |
| | Water-Soluble Plasticizer 3 (Mw< 500) | Viscosity (mPa·s) | | | | | | | |
| | PEG # 600 | 128 | | | | 52.98 | | | |
| | PPG # 3000 | 537 | | | | | | | |
| | Polyglycerin | 37890 | 73.30 | | | | | | 75.83 |
| **Residual Solvent** (Unit: % by mass) | W ater | | | 1.10 | 0.66 | 0.66 | 0.07 | | |
| | Ethanol | | 0.52 | | | | | 1.32 | 0.47 |
| | 1-Butanol | | | | | | 0.71 | | |
| (B)/(A) | | | 2.8 | 0.8 | 2.0 | 2.0 | 1.8 | 0.5 | 3.2 |
| Capturing Property | Sticking Force | | Δ | Δ | ○ | Δ | Δ | Δ | X |
| | Tack | | ○ | ○ | ○ | ○ | ○ | × | ○ |
| Ease of Handling | | | Δ | ○ | ○ | Δ | ○ | ○ | × |

Comparison of each Example (Examples 1 to 13) with Comparative Example 1 shows, from the evaluation results of tackiness, that the tack is weak and the momentum of the test ball cannot be stopped when the ratio ((B)/(A)) of the content of the (B) water-soluble plasticizer to the content of the (A) water-soluble adhesive is 0.5 or less and the ratio of the component (A) that is a solid content is less than a predetermined value. That is, it is found that since the weak tack makes the sheet more elastic in its characteristics, the ability to receive components that have collided with the sheet decreases in Comparative Example 1, whereas the impact absorption is sufficient in each of Examples.

Further, comparison of each Example (Examples 1 to 13) with Comparative Example 2 shows, from the evaluation results of sticking force and ease of handling, that the sheet is stretched when the ratio ((B)/(A)) of the content of the (B) water-soluble plasticizer to the content of the (A) water-soluble adhesive is more than 3.0 and the ratio of the component (B) that is a liquid content is more than a predetermined value. Accordingly, it is found that the sheet of Comparative Example 2 has reduced stickiness and is less easy to handle, making it difficult to use it industrially, whereas the sheet of each Example has a sufficient sticking force and is good in handling.

### INDUSTRIAL APPLICABILITY

The water-soluble adhesive composition for component capture and the water-soluble adhesive sheet for component capture of the present invention can be suitably used as a capturing composition and a capturing sheet for components. They are particularly suitable as a member for placing semiconductor elements on a substrate in the production of electronic components.

Further, the method for producing an electronic component according to the present invention is suitably used as a production method by which it is made easy to capture a component (such as a semiconductor element) at a desired position on a substrate and which allows high-precision and efficient production.

### DESCRIPTION OF REFERENCE CHARACTERS

- 1A, 1B: Transfer Target Substrate
- 11A, 11B: Water-Soluble Adhesive Sheet For Component Capture
- 12A, 12B: Wiring Substrate
- 2A, 2B, 2C, 2D: Transfer Source Substrate
- 21A, 21B, 21C, 21D: Semiconductor Element
- 22A, 22B, 22C, 22D: Sticky Layer
- 23A, 23B, 23C, 23D: Holding Substrate
- 3: Energy Beam

## Claims

1. A water-soluble adhesive composition for component capture containing an (A) water-soluble adhesive and a (B) water-soluble plasticizer (excluding the component (A)), wherein
the (B) water-soluble plasticizer has a viscosity of 50000 mPa·s or less at normal temperature (25°C), and a ratio ((B)/(A)) of a content of the (B) water-soluble plasticizer to a content of the (A) water-soluble adhesive is greater than 0.5 and 3.0 or less.

2. A water-soluble adhesive composition for component capture containing an (A) water-soluble adhesive and a (B) water-soluble plasticizer (excluding the component (A)), wherein
the (B) water-soluble plasticizer is in liquid form at normal temperature (25°C) and has a molecular weight of 5000 or less, and a ratio ((B)/(A)) of a content of the (B) water-soluble plasticizer to a content of the (A) water-soluble adhesive is greater than 0.5 and 3.0 or less.

3. A water-soluble adhesive composition for component capture containing an (A) water-soluble adhesive and a (B) water-soluble plasticizer (excluding the component (A)), wherein
the (A) water-soluble adhesive has a weight-average molecular weight of 1.0 × 10⁴ or more and 1.0 × 10⁶ or less, and a ratio ((B)/(A)) of a content of the (B) water-soluble plasticizer to a content of the (A) water-soluble adhesive is greater than 0.5 and 3.0 or less.

4. The water-soluble adhesive composition for component capture of claim 1, 2, or 3, wherein
the (A) water-soluble adhesive contains at least one kind of water-soluble adhesive selected from the group consisting of a vinyl alcohol-based polymer, a vinylpyrrolidone-based polymer, an acrylic polymer, and saccharide.

5. The water-soluble adhesive composition for component capture of claim 1, 2, or 3, wherein
the (B) water-soluble plasticizer is a monohydric or polyhydric alcohol of a liquid at normal temperature (25°C).

6. The water-soluble adhesive composition for component capture of claim 1, 2, or 3, wherein
the (B) water-soluble plasticizer has a boiling point of 120°C or higher.

7. The water-soluble adhesive composition for component capture of claim 1, 2, or 3, wherein
the (B) water-soluble plasticizer contains at least one kind selected from glycerin, diglycerin, polyethylene glycol, ethylene glycol, propylene glycol, and polypropylene glycol.

8. A water-soluble adhesive sheet for component capture, comprising:
a layer as a sheet made of the water-soluble adhesive composition for component capture of claim 1, 2, or 3.

9. A method for producing an electronic component, the method comprising:
capturing a component using the water-soluble adhesive composition for component capture of claim 1, 2, or 3.

10. A method for producing an electronic component, the method comprising:
capturing a component using the water-soluble adhesive sheet for component capture of claim 8.
